## Europäisches Patentamt
## European Patent Office
## Office européen des brevets

(19)

(11) Veröffentlichungsnummer : **0 036 579**
**B1**

(12) **EUROPÄISCHE PATENTSCHRIFT**

(45) Veröffentlichungstag der Patentschrift :
26.09.84

(51) Int. Cl.³ : **G 11 C 11/24**

(21) Anmeldenummer : **81101843.1**

(22) Anmeldetag : **12.03.81**

(54) **Verfahren zum Regenerieren von in einem dynamischen MOS-Speicher gespeicherten Daten.**

(30) Priorität : **14.03.80 DE 3009872**

(43) Veröffentlichungstag der Anmeldung :
**30.09.81 Patentblatt 81/39**

(45) Bekanntmachung des Hinweises auf die Patenterteilung : **26.09.84 Patentblatt 84/39**

(84) Benannte Vertragsstaaten :
**CH FR GB IT LI NL SE**

(56) Entgegenhaltungen :
**US-A- 3 760 379**
**US-A- 3 997 872**
**US-A- 4 133 051**
**IBM TECHNICAL DISCLOSURE BULLETIN, Band 22, Nr. 5, Oktober 1979, Seite 1883 New York, U.S.A. M. KERRIGAN et al.: "Dynamic memory refresh sequence for asynchronous processor"**
**THE SEMICONDUCTOR MEMORY BOOK, 1978, Ausg. John Wiley & Sons Seiten 412-468 New York, U.S.A. J. OLIPHANT: "Using support circuits for dynamic RAMs"**
**ELECTRONIC ENGINEERING, Band 51, Nr. 620, April 1979, Seiten 95-101 London, G.B. EVANS: "Designing with 16k and 64k dynamic RAMs"**

(73) Patentinhaber : **Siemens Aktiengesellschaft Berlin und München Wittelsbacherplatz 2 D-8000 München 2 (DE)**

(72) Erfinder : **Ludwig, Volker, Dipl.-Ing. Siedlungsstrasse 9 (Gelting) D-8192 Geretsried (DE)**
Erfinder : **Heitmann, Jürgen, Dr.-Ing. Aidenbachstrasse 223 D-8000 München 71 (DE)**

**Beschreibung**

Die Erfindung bezieht sich auf ein Verfahren zum Regenerieren von in einem dynamischen MOS-Speicher gespeicherten Daten entsprechend dem Oberbegriff des Anspruchs 1.

Als Arbeitsspeicher für Mikrorechnersysteme werden häufig statische oder dynamische MOS-Speicher verwendet. Bei statischen Speichern besteht die einzelne Speicherzelle aus einem Flipflop. Bei dynamischen Speichern wird die Speicherzelle aus einem Transistor und einem Kondensator geringer Kapazität gebildet. Die Speicherzelle eines dynamischen MOS-Speichers erfordert damit bei der Herstellung als integrierter Schaltkreis eine wesentlich geringere Fläche, so daß ein etwa vierfacher Integrationsgrad gegenüber einem statischen MOS-Speicher erreicht wird. Daraus ergeben sich auch wesentlich niedrigere Kosten für einen dynamischen MOS-Speicher. Außerdem ist der Leistungsbedarf eines dynamischen MOS-Speichers wesentlich geringer. Der dynamische MOS-Speicher hat allerdings gegenüber dem statischen MOS-Speicher hat allerdings gegenüber dem statischen MOS-Speicher einen wesentlichen Nachteil : In den Kondensatoren tritt durch Entladeströme ein allmählicher Verlust der gespeicherten Ladung und damit der gespeicherten Daten auf. Um dies zu verhindern, müssen die Daten spätestens nach jeweils einer vorgegebenen Zeitdauer regeneriert werden (englisch : refresh). Diese vorgegebene Zeitdauer ist beispielsweise 2 ms.

Die Speicherzellen derartiger MOS-Speicher sind üblicherweise matrixförmig organisiert. Die Adressierung erfolgt dann durch Zeilen- und Spaltenadressen. Bei einem Lesevorgang oder bei Anlegen der Zeilenadressen werden gleichzeitig alle Zelleninhalte einer Zeile regeneriert. Es besteht nun einerseits die Möglichkeit, nach jeweils der vorgegebenen Zeitdauer zeitlich unmittelbar aneinander anschließend die Daten aller Zeilen zu regenerieren. Dieser Vorgang wird als « Burst-Refresh » bezeichnet. Andererseits gibt es die Möglichkeit, die Regenerierungsvorgänge verteilt durchzuführen, so daß auch während der Regenerierungsvorgänge jeweils einer bestimmten Zeile Speichervorgänge in anderen Zeilen durchgeführt werden können. Die Zeitdauer, nach der in diesem Fall spätestens ein Regenerierungsvorgang durchgeführt werden muß, ergibt sich aus dem Quotienten der vorgegebenen Zeitdauer durch die Anzahl der Zeilen. Dieser Vorgang wird als « verteilter Refresh » bezeichnet. Wenn der Speicher als Arbeitsspeicher eines Mikrorechnersystems verwendet wird, werden die Regenerierungsvorgänge üblicherweise durch den Mikrorechner gesteuert, indem nach jeweils einer vorgegebenen Anzahl von Zyklen des Mikrorechners ein Regenerierungsvorgang für den Speicher eingeschoben wird.

Der Burst-Refresh hat gegenüber dem verteilten Refresh einerseits den Nachteil, daß während der aufeinanderfolgenden Regenerierungsvorgänge alle Speicherbausteine ihre Arbeitsverlustleistung verbrauchen und daß andererseits während dieser Zeitdauer ein direkter Zugriff zum Speicher von peripheren Speichern nicht möglich ist. Auch bei einem vom Mikrorechner gesteuerten verteilten Refresh führt ein willkürlicher Speicherzugriff von einem peripheren Speicher zu großen Schwierigkeiten.

Aus der Literaturstelle « IBM Technical Disclosure Bulletin », Bd. 22, Nr. 5, Okt. 1979, Seite 1883 ist bereits ein Verfahren bekannt, bei dem zwischen von einem Mikrorechner ausgelösten Speichervorgängen wie Lese- oder Schreibvorgängen Regenerierungsvorgänge eingefügt werden, mit denen zeitlich nacheinander jeweils die Daten des Speichers regeneriert werden und bei dem die Daten spätestens nach einer vorgegebenen Zeitdauer regeneriert werden. Die Regenerierungsvorgänge werden unabhängig von den Speichervorgängen durchgeführt und erfolgen nach einer Zeitdauer, die um eine einem Speichervorgang zugeordnete Zeitdauer gegenüber der vorgegebenen Zeitdauer verkürzt ist. Die Durchführung eines Lesevorgangs während eines Regenerierungsvorganges wird bis zu dessen Abschluß verzögert. Während eines Speichervorgangs wird die Durchführung des Regenerierungsvorgangs verzögert, bis der Speichervorgang abgeschlossen ist. Bei diesem bekannten Verfahren tritt bei jedem Regenerierungsvorgang ein Wartesignal auf.

Der Erfindung liegt daher die Aufgabe zugrunde, ein Verfahren zum Regenerieren von in einem dynamischen MOS-Speicher gespeicherten Daten anzugeben, der als Arbeitsspeicher eines Mikrorechnersystems dient und auf den von einem peripheren Speicher jederzeit zugegriffen werden kann.

Erfindungsgemäß wird die Aufgabe bei dem Verfahren der eingangs genannten Art durch die im kennzeichnenden Teil des Anspruches 1 angegebenen Merkmale gelöst.

Das Verfahren gemäß der vorliegenden Erfindung hat den Vorteil, daß die Verarbeitungsgeschwindigkeit des Mikrorechners durch die Regenerierungsvorgänge nur geringfügig verringert wird, da lediglich beim Lesevorgang eine Verzögerung durch einen Regenerierungsvorgang stattfinden kann.

Zur Verzögerung des Lesevorgangs ist nur ein geringer Aufwand erforderlich, wenn mit Hilfe eines Wartesignals die Verzögerung des Lesevorgangs um einen Wartezyklus erfolgt, während dessen der jeweils gerade ablaufende Regenerierungsvorgang abgeschlossen wird.

Zur Vermeidung einer zeitlichen Kollision eines Regenerierungsvorgangs und eines Speichervorgangs ist es vorteilhaft, wenn bei einem gleichzeitigen Auftreten von einen Regenerierungsvorgang und einen Speichervorgang einleitenden Signalen die Reihenfolge der Durchführung der Vorgänge festgelegt wird.

Im folgenden wird eine Durchführung des Verfahrens gemäß der Erfindung anhand von Zeichnungen erläutert. Es zeigen :

Figur 1 ein Blockschaltbild einer an einem Mikrorechner angeschlossenen Speichereinheit und einer zugehörigen Steuereinheit,

Figur 2 ein Blockschaltbild der Speichereinheit und der Steuereinheit.

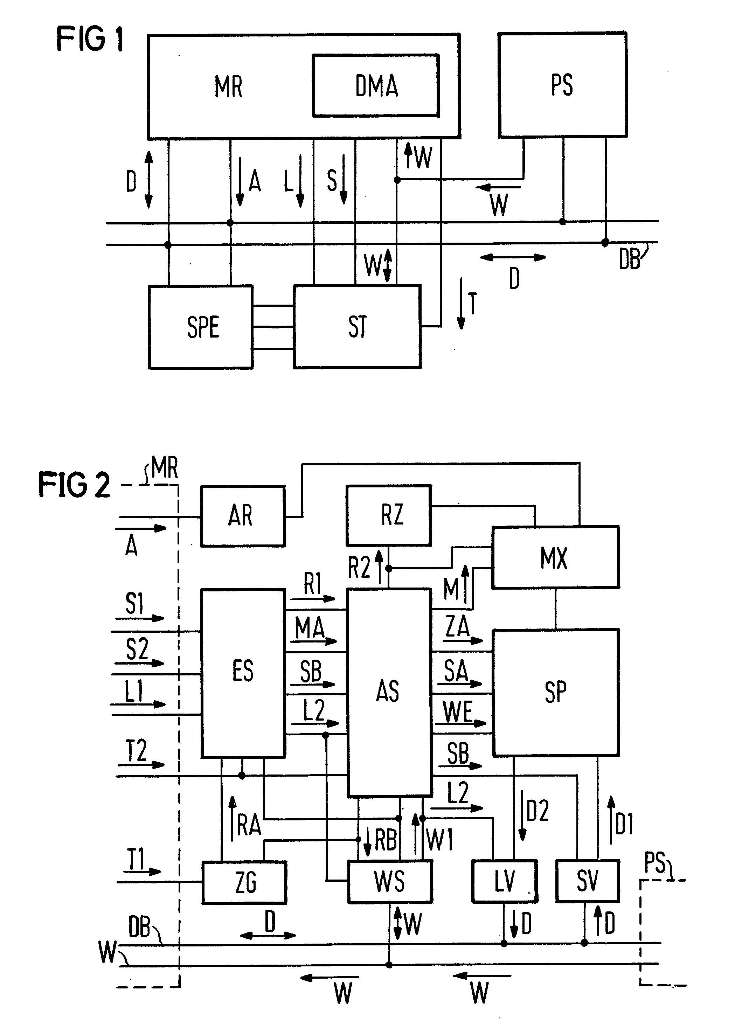

Bei dem in Fig. 1 dargestellten Blockschaltbild ist ein Mikrorechner MR über einen Datenbus DB einerseits mit einer Speichereinheit SPE und andererseits mit einem peripheren Speicher PS verbunden. An dem Datenbus DB können noch weitere Einheiten, wie beispielsweise Ein- und Ausgabeeinheiten oder ein Festwertspeicher angeschlossen sein. Der Mikrorechner MR ist in bekannter Weise ausgestaltet und umfaßt eine programmierbare DMA-Steuereinheit (Direct Memory Access) für einen direkten Speicherzugriff, die im Handel beispielsweise unter der Bezeichnung 8257 erhältlich ist. Weiterhin enthält der Mikrorechner einen Taktgeber, der Taktimpulse T erzeugt. Mit der Speichereinheit SPE ist eine Steuereinheit ST verbunden, die den zeitlichen Ablauf der Speichervorgänge, d. h. der Lese- und Schreibvorgänge steuert. Die Speichereinheit SPE enthält einen dynamischen MOS-Speicher, dessen Inhalt spätestens nach jeweils einer vorgegebenen.

## Ansprüche

1. Verfahren zum Regenerieren von in einem dynamischen MOS-Speicher gespeicherten Daten, bei dem zwischen von einem Mikrorechner oder einer programmierbaren Steuereinheit für einen direkten Speicherzugriff ausgelösten Speichervorgängen, wie Lese- oder Schreibvorgängen, aber unabhängig von den Speichervorgängen, Regenerierungsvorgänge eingefügt werden, mit denen jeweils zeitlich nacheinander jeweils die Daten einer Zeile des Speichers regeneriert werden, wobei die Daten jeder Zeile nach einer um die einem Speichervorgang zugeordnete Zeitdauer verkürzten, für den MOS-Speicher vorgegebenen Zeitdauer regeneriert werden, und bei dem die Durchführung der Lesevorgänge während eines Regenerierungsvorgangs bis zu dessen Abschluß verzögert wird, dadurch gekennzeichnet, daß in einer Zeitdauer, die größer ist als die für einen Regenerierungsvorgang erforderliche Zeitdauer vor dem eigentlichen Schreibvorgang ein Schreibsignal (S1) erzeugt wird, daß beim Auftreten des Schreibsignals (S1) ein gerade ablaufender Regenerierungsvorgang vollständig durchgeführt wird, bevor anschließend der eigentliche Schreibvorgang durchgeführt wird, daß zwischen dem Auftreten des Schreibsignals (S1) und dem Abschluß des eigentlichen Schreibvorgangs die Einleitung einer neuen Regenerierung verhindert wird, und daß mit Hilfe eines Wartesignals (W) die Verzögerung des Lesevorgangs um nur einen Wartezyklus erfolgt, während dem der jeweils gerade ablaufende Regenerierungsvorgang abgeschlossen wird.

2. Verfahren nach Anspruch 1, dadurch gekennzeichnet, daß bei einem gleichzeitigen Auftreten von einen Regenerierungsvorgang und einen Speichervorgang einleitenden Signalen (S1, L1) die Reihenfolge der Durchführung der Vorgänge festgelegt wird.

## Claims

1. A method for refreshing data stored in a dynamic MOS store, wherein between storage operations, such as read or write operations, but independently of the storage operations, which are triggered by a microcomputer or a programmable control unit for a direct store access, there are inserted refreshing operations, by means of which the data of a row of the store are respectively refreshed consecutively in time, where the data of each line are refreshed after a period of time which is predetermined for the MOS store and shortened by the period of time assigned to a storage operation, and wherein the performance of the read operations during a refreshing operation is delayed until the termination of the latter, characterised in that in a period of time which is greater than the period of time required for a refreshing operation a write signal (S1) is produced before the actual write operation, that on occurrence of the write signal (S1) a currently executed refreshing operation is completely carried out before the actual write operation is subsequently effected, that between the occurrence of the write signal (S1) and the termination of the actual write operation the introduction of a new refreshing step is prevented, and that with the aid of a wait signal (W) the delay of the read operation by only one waiting cycle is effected, during which the currently executed refreshing operation is terminated.

2. A method as claimed in claim 1, characterised in that on simultaneous occurrence of signals (S1, L1) introducing a refreshing operation and a storage operation, the sequence of the performance of the operations. is determined.

## Revendications

1. Procédé pour régénérer des données mémorisées dans une mémoire dynamique MOS, dans lequel on insère entre des opérations de mémorisation telles que des opérations de lecture ou d'écriture déclenchées pour un accès direct à la mémoire par un microcalculateur ou par une unité de commande programmable, mais indépendamment d'opérations de mémorisation, des opérations de régénération à l'aide desquelles on régénère successivement dans le temps les données d'une ligne de la mémoire, les données de chaque ligne étant régénérées, pour une durée prédéterminée de la mémoire MOS, d'une durée raccourcie et associée à une opération de mémorisation, et dans lequel l'exécution des opérations de lecture est retardée pendant une opération de régénération et jusqu'à la fin de celle-ci, caractérisé par le fait que pendant une durée qui est supérieure à la durée nécessaire pour une opération de régénération, et avant l'opération d'écriture proprement dite, on produit un signal d'écriture (S1), qu'à l'apparition du signal d'écriture, une opération de régénération qui est en cours est entièrement réalisée avant que soit réalisée l'opération d'écriture proprement dite, qu'entre l'apparition du signal d'écriture (S1) et la fin de l'opération d'écriture proprement dite, l'initialisation d'une nouvelle régénération est empêchée, et qu'à l'aide d'un signal d'attente (W) le retard de l'opération de lecture n'a lieu que pour un cycle d'attente pendant lequel est achevée l'opération de régénération qui est en cours.

2. Procédé selon la revendication 1, caractérisé par le fait que dans le cas d'une apparition simultanée de signaux (S1, L1) l'initialisation d'une opération de régénération et d'une opération de mémorisation, l'ordre d'exécution des opérations est déterminé.

FIG 1

FIG 2